# FASCICULE DE BREVET EUROPEEN

(11) **EP 2 975 639 B1**
(45) Date de publication et mention de la délivrance du brevet: **27.07.2016**
(21) Numéro de dépôt: 15175045.2
(22) Date de dépôt: 02.07.2015
(51) Int. Cl.: H01L 23/373

(54) **Dispositif d'interface thermique avec joint microporeux capable d'empecher la migration de graisse thermique**
Thermische schnittstellenvorrichtung mit mikroporöser verbindung, die in der lage ist, die migration von wärmeleitpaste zu verhindern
Thermal interface device with microporous seal capable of preventing migration of thermal grease

(30) Priorité: 18.07.2014 FR 1401617
(43) Date de publication de la demande: 20.01.2016
(73) Titulaire: THALES, 92400 Courbevoie (FR)
(72) Inventeur: JOUANNE, Pierre, 83440 FAYENCE (FR); LEGRAND, Silvain, 06000 NICE (FR); DAMIANO, Olivier, 83600 LES ADRETS DE L'ESTEREL (FR)
(74) Mandataire: Derval, Estelle

(56) Documents cités:
- WO-A1-98/20549
- JP-A- H03 148 199
- JP-A- 2003 168 772
- JP-A- 2013 251 473

## Description

La présente invention concerne le domaine des matériaux d'interface thermique, plus précisément elle porte sur la mise en oeuvre d'une graisse thermique ceinturée par un joint microporeux permettant de limiter les phénomènes de migration, ou *pump out,* de la graisse thermique. L'invention trouve une utilité particulière dans le domaine aérospatiale pour la fixation d'équipement dissipatif sur une structure porteuse.

On a recours aux matériaux d'interface thermique, aussi connus par l'acronyme anglais TIM pour *Thermal Interface Material* en anglais, pour favoriser les échanges thermiques entre un équipement générant ou transportant de la chaleur et une structure porteuse. On connait plusieurs types de matériaux d'interface thermique, et en particulier les graisses thermiques, ou *thermal grease* en anglais. Une graisse thermique comprend généralement un liant, comme par exemple un polymère siliconé, et une charge favorisant le transfert thermique. Dans un exemple connu, des particules métalliques d'oxyde de bore sont dispersées dans une matrice de polymère siliconé de type polydiméthylsiloxane ou PDMS.

Les graisses thermiques sont notamment mises en oeuvre pour favoriser l'évacuation de chaleur de cartes électroniques tels que les processeurs d'ordinateur. La dissipation de chaleur constitue également une difficulté particulière dans le domaine aérospatial, d'une part en raison des fortes variations de température rencontrées par le satellite au cours de sa mission, et d'autre part en raison de l'absence d'atmosphère gazeuse limitant les échanges de chaleurs vers l'extérieur du satellite. Dans une architecture connue d'un satellite à orbite terrestre, une structure porteuse est constituée de panneaux, par exemple des panneaux sandwich en matériaux composites aluminium ou carbone. Divers équipements dissipatifs peuvent être fixés sur ses panneaux, comme par exemple des modules électroniques qui génèrent de la chaleur, ou des radiateurs qui transmettent de la chaleur. Des graisses thermiques sont ainsi mises en oeuvre à l'interface entre ces équipements et les panneaux pour favoriser le transfert de chaleur entre les composants.

Cette mise en oeuvre se heurte toutefois à plusieurs difficultés que la présente invention cherche à résoudre. Une première difficulté porte sur les phénomènes de migration de la graisse thermique, aussi connues par la terminologie anglaise *pump out.* Les équipements dissipatifs et la structure porteuse étant constitués de matériaux différents, ils présentent des comportements thermomécaniques généralement différents. Les oscillations de température, par exemple liées aux cyclages thermiques du satellite en orbite, génèrent un déplacement relatif des équipements dissipatifs et de la structure qui entraine une migration de la graisse et dégrade l'interface thermique entre l'équipement et la structure.

Une seconde difficulté constatée est l'assèchement de la graisse thermique, ou *dry out* en anglais. Le séchage progressif de la graisse en périphérie de l'interface modifie ses propriétés thermomécaniques et dégrade là aussi l'interface thermique entre l'équipement et la structure.

Une troisième difficulté rencontrée concerne le drainage, ou *venting* en anglais, lors du lancement du satellite hors de l'atmosphère ou lors d'une opération de dégazage pour des applications sous vide. L'expulsion de bulles d'air piégées dans la graisse thermique génère un drainage et entraine une partie de la graisse thermique hors de l'interface.

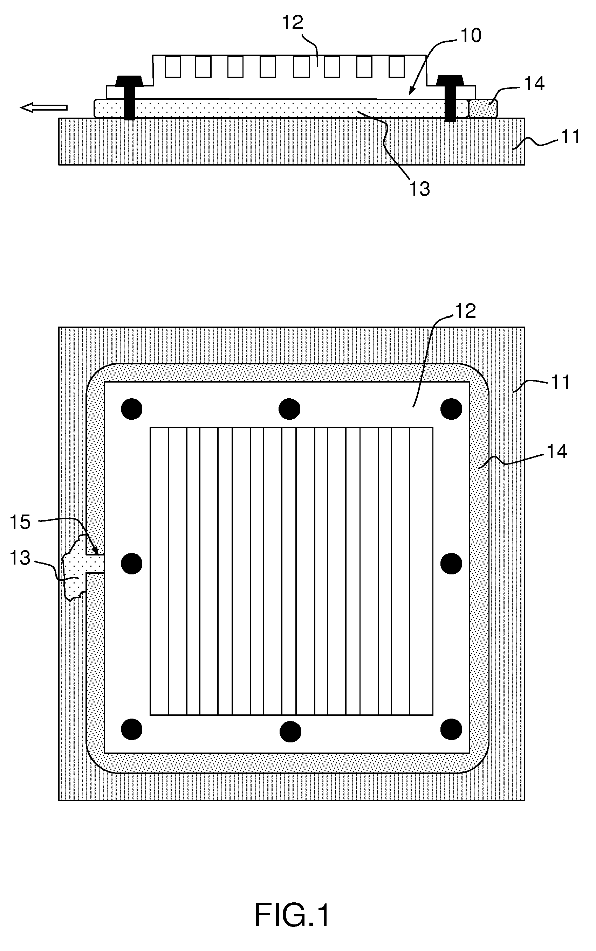

Dans une première approche, on a tenté de résoudre ces difficultés en disposant un joint élastomère en périphérie de la graisse thermique. Le principe et les limites de cette approche sont illustrés par la figure 1. Une interface thermique 10, intercalé entre une structure 11 et un équipement dissipatif 12, comprend une graisse thermique 13 et un joint élastomère 14 disposé sur une partie de la périphérie de la graisse thermique. Le joint élastomère, en contact avec la structure 11 et l'équipement dissipatif 12, assure l'étanchéité entre ces composants et la graisse thermique, permettant de limiter les phénomènes de *pump out* et de *dry out* de l'interface. Le joint élastomère est imperméable aux gaz. Il est donc nécessaire de prévoir un chemin pour permettre l'évacuation des bulles d'air ou *venting,* de la graisse thermique vers l'extérieur. Le joint élastomère ne peut donc pas entourer la graisse thermique sur toute sa périphérie. Au contraire, l'interface comprend un évent 15 par lequel la graisse thermique est en contact avec l'extérieur, permettant le dégazage de la graisse thermique au travers de l'évent 15. Cette première approche souffre cependant de plusieurs limites. Les phénomènes de *pump out* et de *dry out* restent possibles au travers de l'évent. Comme illustré par la figure, une quantité de graisse thermique peut être entrainée sous l'effet des cyclages thermiques hors de l'interface au travers de l'évent, dégradant les performances thermomécaniques de l'interface. Le délai important de polymérisation du joint élastomère (plusieurs jours) ou la complexité de l'application du joint élastomère en périphérie de la graisse thermique constituent également des limites industrielles notables.

2003 168772 A (DENSO CORP; TOYOTA MOTOR CORP) 13 juin 2003 (2003-06-13) divulgue, voir figure 7 et paragraphe 32, un dispositif d'interface thermique qui comprend un film de graisse thermique (12) destiné à être intercalé entre un premier objet et un second objet, et un joint (20) ceinturant en périphérie le film de graisse thermique. Le joint empêche la graisse thermique de s'échapper.

Dans une seconde approche décrite par la demande de brevet publiée sous la référence US6121680, on a tenté de résoudre ces difficultés en piégeant la graisse thermique dans un tissu. Cette approche permet de limiter le phénomène de *pump out* de la graisse piégée dans les mailles du tissu, mais ne résout pas le problème de séchage de la graisse thermique en sa périphérie.

Ainsi, les matériaux d'interface thermique envisagés dans l'état connu de la technique restent limités par les phénomènes de migration des graisses, de séchage et de dégazage. Il reste désirable de disposer d'un matériau d'interface thermique capable d'assurer un transfert de chaleur de manière durable, en supportant les contraintes particulièrement sévères de l'aérospatiale, et notamment les phénomènes de *pump out*, de *dry out* et de *venting*. Le matériau d'interface thermique retenu devra par ailleurs permettre un déploiement industriel simple, notamment en autorisant un dosage précis et reproductible de la graisse thermique.

A cet effet, l'invention a pour objet un dispositif d'interface thermique comprenant un film de graisse thermique destiné à être intercalé entre un premier objet et un second objet, et un joint microporeux ceinturant en périphérie le film de graisse thermique.

Avantageusement, le joint microporeux est oléophobe et perméable à l'air. Autrement dit, le joint microporeux est configuré de façon à piéger la graisse thermique, ou autrement dit empêcher la migration ou *pump out*, tout étant perméable à l'air, ou autrement dit tout en permettant le *venting* ou dégazage.

Avantageusement, le joint microporeux comprend un film microporeux de polytetrafluoroéthylène.

Avantageusement, le joint microporeux comprend une charge électriquement conductrice.

Avantageusement, la graisse thermique comprend un liant et une charge conductrice thermiquement favorisant le transfert thermique, le diamètre moyen des pores du joint microporeux étant inférieur au diamètre moyen de la charge de manière à empêcher la migration de la charge conductrice thermiquement.

Avantageusement, le joint microporeux présente un coefficient de frottement supérieur à 0.25.

Avantageusement, le joint microporeux présente une épaisseur comprise entre 150 et 180 µm.

L'invention porte aussi sur un joint microporeux comprenant sur une face un film adhésif et un film démoulant ; le film démoulant pouvant être retiré pour permettre d'adhérer ladite face du joint microporeux à l'un des deux objets au moyen du film adhésif.

Avantageusement, le joint microporeux comprend sur une face un ruban adhésif pouvant être retiré de manière à permettre de mettre en contact ladite face du joint microporeux à l'un des deux objets.

L'invention porte également sur un équipement comprenant un premier objet, un second objet et un dispositif d'interface thermique ayant les caractéristiques précédemment décrites, intercalé entre le premier objet et le second objet.

L'invention porte enfin sur un procédé de fabrication dudit équipement, caractérisé en ce qu'il comprend des étapes consistant à :
- déposer le joint microporeux sur le premier objet, mettant en contact une première face du joint microporeux avec le premier objet, et de manière à former un cadre fermé sur le premier objet,
- déposer de la graisse thermique sur le premier objet, à l'intérieur du cadre fermé de joint microporeux,
- lisser la graisse thermique au moyen d'un lissoir prenant appui sur le cadre de joint microporeux, permettant de former le film de graisse thermique ceinturée par le joint microporeux, et
- déposer le second objet sur le film de graisse thermique, mettant au moins partiellement en contact une seconde face du joint microporeux avec le second objet.

Avantageusement, le procédé comprend une étape ultérieure de montage de moyens de fixation entre le premier objet et le second objet.

Avantageusement, le procédé comprend une étape préliminaire consistant à retirer un film démoulant du joint microporeux, de manière à découvrir une face du joint microporeux comprenant un film adhésif, l'étape suivante de dépôt du joint microporeux mettant en contact le film adhésif avec le premier objet.

Avantageusement, l'étape de retrait du film démoulant et l'étape de dépôt du joint microporeux sur le premier objet sont réalisées simultanément au moyen d'un dévidoir à rouleau.

Avantageusement, le procédé comprend, à l'issue de l'étape de lissage de la graisse thermique, une étape de retrait d'un ruban adhésif préalablement disposé sur une face du joint microporeux.

L'invention sera mieux comprise et d'autres avantages apparaîtront à la lecture de la description détaillée d'un mode de réalisation donné à titre d'exemple sur les figures suivantes.
La figure 1, déjà présentée, représente un dispositif d'interface thermique intercalé entre un substrat et un équipement dissipatif selon l'état connu de la technique,
la figure 2 représente un exemple de dispositif d'interface thermique selon l'invention, intercalé entre un substrat et un équipement dissipatif,
la figure 3 illustre les étapes d'un premier exemple de procédé de fabrication d'un équipement comprenant un dispositif d'interface thermique selon l'invention intercalé entre un substrat et un équipement dissipatif,
la figure 4 illustre les étapes d'un second exemple de procédé de fabrication d'un équipement comprenant un dispositif d'interface thermique selon l'invention intercalé entre un substrat et un équipement dissipatif,
la figure 5 illustre une mise en oeuvre particulière d'un joint microporeux dans un dévidoir à rouleau pour la réalisation d'un dispositif d'interface thermique selon l'invention.

Par souci de clarté, les mêmes éléments porteront les mêmes repères dans les différentes figures.

L'idée générale de l'invention est de disposer un joint microporeux en périphérie d'un film de graisse thermique. Le joint microporeux ceinture le film de graisse thermique sur toute sa périphérie. Le joint microporeux est oléophobe et perméable à l'air de sorte qu'il piège la graisse thermique, ou autrement dit empêche la migration ou *pump out,* tout étant perméable au gaz, ou autrement dit permet le *venting* ou dégazage.

Le dispositif d'interface thermique ainsi constitué est particulièrement adapté à une application aérospatiale. Dans ce sens, le dispositif d'interface thermique détaillé dans la suite est destiné à être intercalé entre un substrat, i.e. la structure porteuse, et un équipement dissipatif tel qu'un module électronique ou un échangeur de chaleur. Il est bien entendu que l'invention ne se limite pas à cette application particulière dans le domaine aérospatiale. D'une manière générale, l'invention porte sur un dispositif d'interface thermique comprenant un film de graisse thermique destiné à être intercalé entre un premier objet et un second objet, et un joint microporeux ceinturant en périphérie le film de graisse thermique. Sur les figures, le premier objet correspond au substrat et le second objet correspond à l'équipement dissipatif.

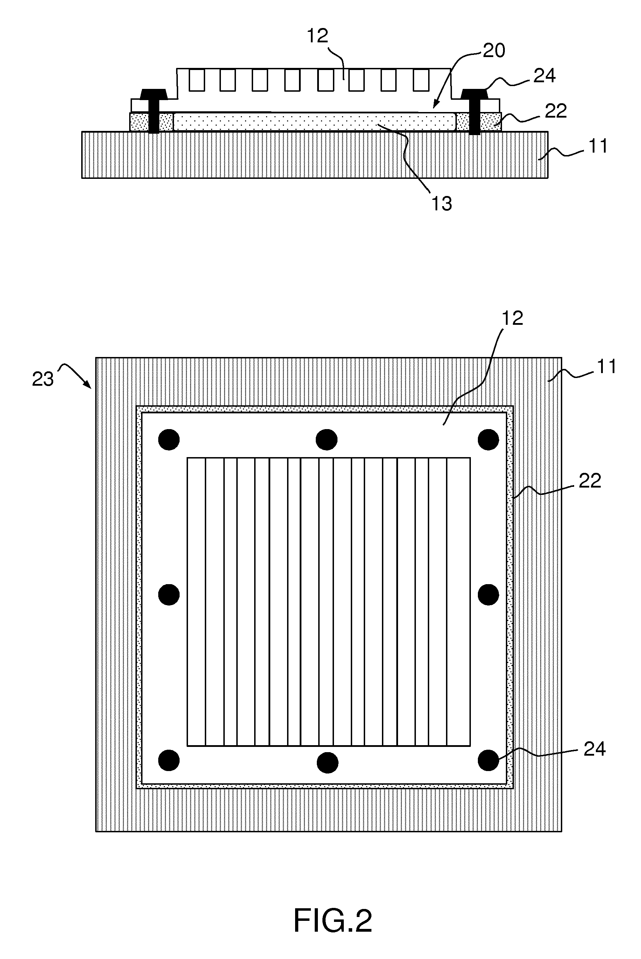

La **figure 2** représente un exemple de dispositif d'interface thermique selon l'invention, intercalé entre un substrat et un équipement dissipatif. Ainsi, le dispositif d'interface thermique 20 comprend un film de graisse thermique 13 entouré sur toute sa périphérie par un joint microporeux 22. Le dispositif d'interface thermique 20 assure le maintien mécanique et le transfert thermique entre un substrat 11 et un équipement dissipatif 12. L'invention porte sur le dispositif d'interface thermique 20 et sur un équipement 23 comprenant le substrat 11, l'équipement dissipatif 12 et le dispositif d'interface thermique 20. L'équipement 23 peut également comprendre des moyens de fixation 24 entre le substrat et l'équipement dissipatif. Les moyens de fixation peuvent être disposés de manière à traverser ou non le joint microporeux ou le film de graisse thermique.

Contrairement aux solutions précédemment décrites de l'état connu de la technique, le film de graisse thermique est entièrement entouré, autrement dit ceinturé, par le joint. Le joint microporeux 22 étant avantageusement perméable au gaz, il n'est pas nécessaire d'aménager une ouverture pour permettre le *venting* de la graisse thermique. L'évacuation d'éventuelles bulles d'air piégées dans la graisse thermique, lors du lancement du satellite ou lors d'une opération de dégazage, se fait au travers des pores de la barrière microporeuse constituée par le joint 22. Contrairement aux solutions connues, la graisse thermique reste alors piégée à l'intérieur de la barrière microporeuse. Le dispositif d'interface thermique s'affranchit ainsi des phénomènes de migration ou *pump out*, ainsi que des phénomènes de séchage ou *dry out* de la graisse thermique.

Notons que dans un souci de lisibilité, la figure 2 représente un joint microporeux aux dimensions extérieures légèrement supérieures aux dimensions externes de l'équipement dissipatif. Cette représentation n'est qu'un exemple de mise en oeuvre possible. Dans une mise en oeuvre alternative, le joint microporeux est ajusté aux dimensions extérieures de l'équipement dissipatif.

Dans une mise en oeuvre particulière de l'invention, le joint microporeux est constitué d'un film microporeux en polytetrafluoroéthylène, ou PTFE. Il présente des pores de diamètre moyen de l'ordre de 5 µm. Il est oléophobe, hydrophobe et perméable à l'air. Le film microporeux en PTFE supporte avantageusement des températures supérieures à 150°C en fonctionnement et supérieures à 200°C en pointe. Il est en outre avantageusement compatible chimiquement compatible avec l'ensemble de constituants chimiques de l'équipement (adhésifs, graisse, solvant, etc...) .

En variante, le joint microporeux comprend un film microporeux de polyetherimide ou PEI, de polyethersulfone ou PES ou de polyimide ou PI.

Le joint microporeux peut avantageusement être configuré de manière à présenter une conductivité électrique élevée, par l'adjonction de charge conductrice à sa matrice polymère, telle que des nanoparticules de carbone. Ainsi, le dispositif d'interface thermique assure une mise à la masse de l'équipement dissipatif sans nécessiter de composant dédié tel que par exemple une tresse métallique.

Comme précisé précédemment, une graisse thermique comprend généralement un liant, comme par exemple un polymère siliconé, et une charge favorisant le transfert thermique. Cette charge est une charge conductrice thermiquement. Avantageusement, le joint microporeux est configuré de façon à empêcher la migration de la charge. Autrement dit, le diamètre moyen des pores du joint microporeux est avantageusement inférieur au diamètre moyen de la charge conductrice de chaleur de manière à empêcher la migration de la charge, c'est-à-dire le « pump out » de la charge. La charge présente typiquement un diamètre compris entre 20 µm et 40 µm.

Avantageusement, le joint microporeux présente des pores dont le diamètre moyen est compris entre 1 µm et 10 µm.

Le joint microporeux peut aussi être avantageusement configuré de manière à présenter un coefficient de frottement supérieur à 0.25. Le joint microporeux s'oppose donc au glissement relatif de l'équipement dissipatif par rapport au substrat, permettant d'abaisser les exigences de maintien mécanique des moyens de fixation.

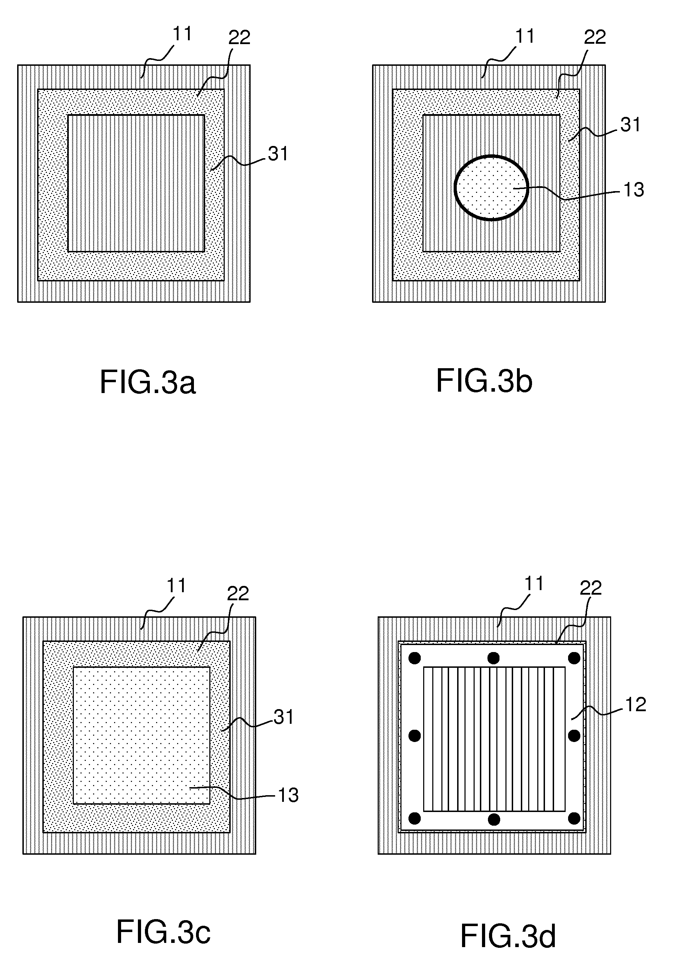

La **figure 3** illustre les étapes d'un premier exemple de procédé de fabrication d'un équipement comprenant un dispositif d'interface thermique selon l'invention intercalé entre un substrat et un équipement dissipatif. Dans ce premier exemple, le procédé de fabrication comprend quatre étapes, illustrées au moyen des quatre schémas (a), (b), (c) et (d) représentant l'équipement en vue de dessus.

Le procédé de fabrication comprend ainsi :
- une première étape (a) consistant à déposer le joint microporeux 22 sur le substrat 11, mettant en contact une première face 30 du joint microporeux 22 avec le substrat 11, et de manière à former un cadre fermé 31 sur le substrat,
- une seconde étape (b) consistant à déposer un cordon de graisse thermique 13 sur le substrat 11, à l'intérieur du cadre fermé 31 formé par le joint microporeux 22,
- une troisième étape (c) consistant à lisser la graisse thermique 13 au moyen d'un lissoir (non représenté) prenant appui sur le cadre 31, permettant de former le film de graisse thermique 13 ceinturée par le joint microporeux 22, et
- une quatrième étape (d) consistant à déposer l'équipement dissipatif 12 sur le film de graisse thermique 13, mettant en contact une seconde face 32 du joint microporeux 22 avec l'équipement dissipatif 12.

Cet exemple de procédé de fabrication est particulièrement avantageux. Il permet de piéger la graisse thermique à l'intérieur du cadre fermé, permettant d'ajuster avec précision l'épaisseur de graisse thermique à l'issue de l'étape de lissage. La quantité de graisse thermique mise en oeuvre et les propriétés thermomécaniques de l'interface thermique ainsi constituée peuvent être aisément maitrisées. Le calibrage de l'épaisseur du film de graisse thermique, au moyen d'un joint microporeux d'épaisseur maitrisée, typiquement de l'ordre de 150 à 180 µm, permet avantageusement d'absorber les défauts de planéité du substrat et/ou de l'équipement dissipatif, tout en assurant un échange thermique optimisé entre ces deux composants. En variante, l'épaisseur du joint est située en dehors de cet intervalle préféré.

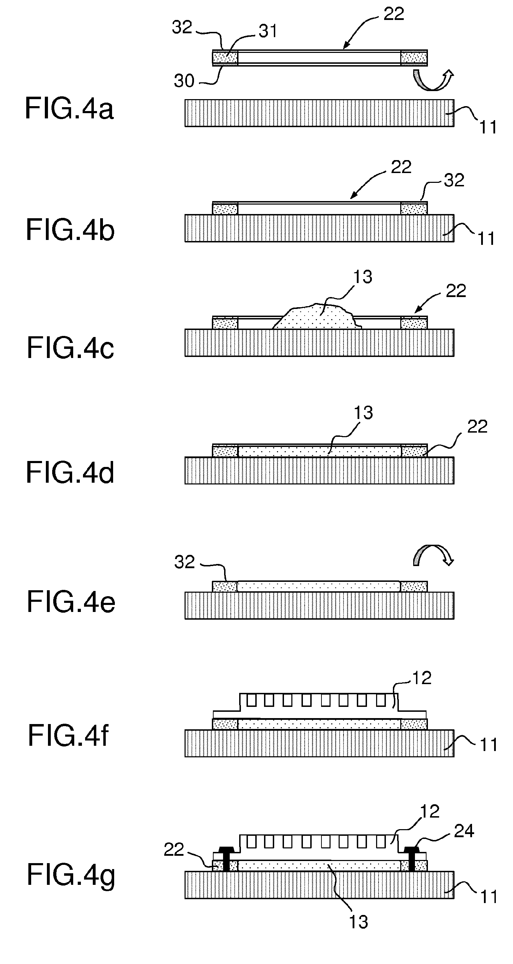

La **figure 4** illustre les étapes d'un second exemple de procédé de fabrication d'un équipement comprenant un dispositif d'interface thermique selon l'invention, intercalé entre un substrat et un équipement dissipatif. Dans ce second exemple, le procédé comprend sept étapes, illustrées au moyen des sept schémas (a') à (g') représentant l'équipement en vue de coté. Ce second exemple comprend les quatre étapes décrites au moyen de la figure 3. Typiquement, les schémas (b'), (c'), (d') et (f') en vue de coté sur la figure 4 correspondent respectivement aux schémas (a), (b), (c) et (d) en vue de dessus de la figure 3. Ce second exemple de procédé comprend aussi trois étapes supplémentaires illustrées par les schémas (a'), (e') et (g') que nous allons détailler.

Comme décrit précédemment, le film microporeux 22 comprend une première face 30, destiné à venir en contact du substrat en formant un cadre fermé 31 sur celui-ci, et une seconde face 32 destiné à venir en contact de l'équipement dissipatif, après dépôt et lissage de la graisse thermique à l'intérieur du cadre fermé 31.

Dans une mise en oeuvre particulière, la première face 30 est adhésivée pour permettre la mise en place et le maintien du cadre fermé 31 sur le substrat, par exemple au moyen d'un adhésif de transfert acrylique ou silicone. Avantageusement, le joint microporeux peut comprendre sur sa première face 30 un film adhésif déposé sur le film en PTFE, et un film démoulant protégeant le film adhésif avant l'étape de dépôt du joint microporeux sur le substrat. Autrement dit, le procédé peut comprendre une étape préliminaire, illustrée par le schéma (a'), consistant à retirer le film démoulant du joint microporeux, de manière à découvrir la face 30 munie du film adhésif. L'étape ultérieure de dépôt du joint microporeux sur le substrat, illustrée par le schéma (b'), met alors en contact le film adhésif du joint avec le substrat.

Selon un principe similaire, la seconde face 32 peut avantageusement comprendre un ruban adhésif, aussi appelé *liner*, permettant le lissage de la graisse thermique sans colmatage des microporosités du film microporeux. Avantageusement, le ruban est très légèrement adhésivé de manière à permettre son retrait après l'étape de lissage de la graisse thermique, sans endommager par décollement le film microporeux déposée sur le substrat. Autrement dit, le procédé peut comprendre une étape, illustrée par le schéma (e'), consistant à retirer le ruban adhésif préalablement disposé sur la seconde face du joint microporeux, permettant le lissage de la graisse thermique sans colmatage du joint microporeux.

Enfin le procédé peut aussi comprendre une étape ultérieure, illustrée par le schéma (g'), de montage de moyens de fixation 24 entre le substrat et l'équipement dissipatif.

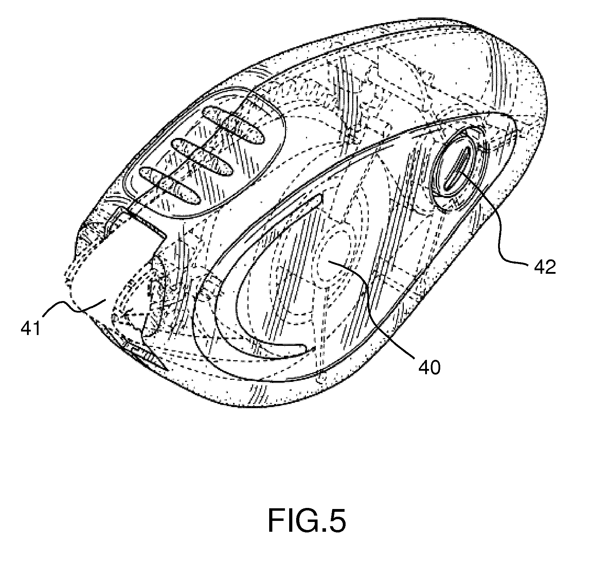

La **figure 5** illustre une mise en oeuvre particulière d'un joint microporeux dans un dévidoir à rouleau pour la réalisation d'un dispositif d'interface thermique selon l'invention. Ce type de dévidoir bien connu dans le domaine de la papeterie peut être avantageusement mis en oeuvre dans le contexte de la présente invention pour simplifier l'étape de dépôt du film microporeux et la formation du cadre fermé 31 le long d'un contour préalablement repéré. Dans ce cas, l'étape de retrait du film démoulant illustrée par le schéma (a') et l'étape de dépôt du joint microporeux sur le substrat - illustrée par le schéma (b') - sont réalisées simultanément au moyen du dévidoir à rouleau. Typiquement, le joint microporeux est enroulé sur un premier rouleau 40. Il est déposé sur le substrat au moyen du bec 41 ; le film démoulant étant simultanément retiré de la face adhésivée 31 du film microporeux et enroulé sur un second rouleau 42.

## Revendications

1. Dispositif d'interface thermique **caractérisé en ce qu'**il comprend un film de graisse thermique (13) destiné à être intercalé entre un premier objet (11) et un second objet (12), et un joint microporeux (22) ceinturant en périphérie le film de graisse thermique (13).

2. Dispositif d'interface thermique selon la revendication précédente, dans lequel le joint microporeux (22) est oléophobe et perméable à l'air.

3. Dispositif selon l'une quelconque des revendications précédentes, dont le joint microporeux (22) comprend un film microporeux de polytetrafluoroéthylène (PTFE).

4. Dispositif selon l'une des revendications précédentes, dont le joint microporeux (22) comprend une charge électriquement conductrice.

5. Dispositif selon l'une quelconque des revendications précédentes, dans lequel la graisse thermique comprend un liant et une charge conductrice thermiquement favorisant le transfert thermique, le diamètre moyen des pores du joint microporeux étant inférieur au diamètre moyen de la charge de manière à empêcher la migration de la charge conductrice thermiquement.

6. Dispositif selon l'une des revendications précédentes, dont le joint microporeux (22) présente un coefficient de frottement supérieur à 0.25.

7. Dispositif selon l'une des revendications précédentes, dont le joint microporeux (22) présente une épaisseur comprise entre 150 et 180 µm.

8. Joint microporeux (22) d'un dispositif d'interface thermique (20) selon l'une des revendications 1 à 7, **caractérisé en ce qu'**il comprend sur une face (30) un film adhésif et un film démoulant ; le film démoulant pouvant être retiré pour permettre d'adhérer ladite face (30) du joint microporeux (22) à l'un des deux objets (11, 12) au moyen du film adhésif.

9. Joint microporeux (22) d'un dispositif d'interface thermique (20) selon l'une des revendications 1 à 7, **caractérisé en ce qu'**il comprend sur une face (32) un ruban adhésif pouvant être retiré de manière à permettre de mettre en contact ladite face (32) du joint microporeux (22) à l'un des deux objets (11, 12).

10. Equipement (23) comprenant un premier objet (11) et un second objet (12) **caractérisé en ce qu'**il comprend un dispositif d'interface thermique (20) selon l'une des revendications 1 à 7 intercalé entre le premier objet (11) et le second objet (12).

11. Procédé de fabrication d'un équipement (23) selon la revendication 10, **caractérisé en ce qu'**il comprend des étapes consistant à :
• déposer le joint microporeux (22) sur le premier objet (11), mettant en contact une première face (30) du joint microporeux (32) avec le premier objet (11), et de manière à former un cadre fermé (31) sur le premier objet (11),
• déposer de la graisse thermique (13) sur le premier objet (11), à l'intérieur du cadre fermé (31) de joint microporeux (22),
• lisser la graisse thermique (13) au moyen d'un lissoir prenant appui sur le cadre (31) de joint microporeux (22), permettant de former le film de graisse thermique (13) ceinturée par le joint microporeux (22), et
• déposer le second objet (12) sur le film de graisse thermique (13), mettant au moins partiellement en contact une seconde face (32) du joint microporeux (22) avec le second objet (12).

12. Procédé selon la revendication 11, comprenant une étape ultérieure de montage de moyens de fixation (24) entre le premier objet (11) et le second objet (12).

13. Procédé selon l'une des revendications 11 à 12, comprenant une étape préliminaire consistant à retirer un film démoulant du joint microporeux (22), de manière à découvrir une face (30) du joint microporeux (22) comprenant un film adhésif, l'étape suivante de dépôt du joint microporeux (22) mettant en contact le film adhésif avec le premier objet (11).

14. Procédé selon la revendication 13, dont l'étape de retrait du film démoulant et l'étape de dépôt du joint microporeux (22) sur le premier objet (11) sont réalisées simultanément au moyen d'un dévidoir à rouleau.

15. Procédé selon l'une des revendications 11 à 14, comprenant à l'issue de l'étape de lissage de la graisse thermique (13), une étape de retrait d'un ruban adhésif préalablement disposé sur une face (32) du joint microporeux (22).

## Patentansprüche

1. Thermische Schnittstellenvorrichtung, **dadurch gekennzeichnet, dass** sie einen thermischen Fettfilm (13), der dazu bestimmt ist, zwischen einem ersten Objekt (11) und einem zweiten Objekt (12) eingefügt zu werden, und eine mikroporöse Verbindung (22), die den thermischen Fettfilm (13) am Rand umgibt, umfasst.

2. Thermische Schnittstellenvorrichtung gemäß dem vorangehenden Anspruch, deren mikroporöse Verbindung (22) ölabweisend und luftdurchlässig ist.

3. Vorrichtung nach einem der vorangehenden Ansprüche, deren mikroporöse Verbindung (22) einen mikroporösen Film aus Polytetrafluorethylen (PTFE) umfasst.

4. Vorrichtung nach einem der vorangehenden Ansprüche, deren mikroporöse Verbindung (22) einen elektrisch leitfähigen Füllstoff umfasst.

5. Vorrichtung nach einem der vorangehenden Ansprüche, bei der das thermische Fett ein Bindemittel und einen wärmeleitfähigen Füllstoff umfasst, welche die Wärmeübertragung begünstigen, wobei der durchschnittliche Durchmesser der Poren der mikroporösen Verbindung geringer ist als der durchschnittliche Durchmesser des Füllstoffs, sodass die Migration des wärmeleitfähigen Füllstoffs verhindert wird.

6. Vorrichtung nach einem der vorangehenden Ansprüche, deren mikroporöse Verbindung (22) eine Reibungszahl über 0,25 aufweist.

7. Vorrichtung nach einem der vorangehenden Ansprüche, deren mikroporöse Verbindung (22) eine Stärke zwischen 150 und 180 µm aufweist.

8. Mikroporöse Verbindung (22) einer thermischen Schnittstellenvorrichtung (20) nach einem der Ansprüche 1 bis 7, **dadurch gekennzeichnet, dass** sie auf einer Seite (30) eine Klebefolie und eine Schutzfolie umfasst, wobei die Schutzfolie abgezogen werden kann, um die Seite (30) der mikroporösen Verbindung (22) mit Hilfe der Klebefolie auf eines der beiden Objekte (11, 12) kleben zu können.

9. Mikroporöse Verbindung (22) einer thermischen Schnittstellenvorrichtung (20) nach einem der Ansprüche 1 bis 7, **dadurch gekennzeichnet, dass** sie auf einer Seite (32) einen Klebestreifen umfasst, der abgezogen werden kann, um die Seite (32) der mikroporösen Verbindung (22) in Kontakt mit einem der beiden Objekte (11, 12) bringen zu können.

10. Ausrüstung (23), umfassend ein erstes Objekt (11) und ein zweites Objekt (12), **dadurch gekennzeichnet, dass** sie eine thermische Schnittstellenvorrichtung (20) gemäß einem der Ansprüche 1 bis 7 umfasst, die zwischen dem ersten Objekt (11) und dem zweiten Objekt (12) eingefügt ist.

11. Verfahren zur Herstellung einer Ausrüstung (23) gemäß Anspruch 10, **dadurch gekennzeichnet, dass** es die folgenden Schritte umfasst:
• Aufbringen der mikroporösen Verbindung (22) auf das erste Objekt (11), sodass eine erste Seite (30) der mikroporösen Verbindung (32) mit dem ersten Objekt (11) in Kontakt gebracht wird und sodass ein geschlossener Rahmen (31) auf dem ersten Objekt (11) gebildet wird,
• Aufbringen von thermischem Fett (13) auf dem ersten Objekt (11) im Inneren des geschlossenen Rahmens (31) aus der mikroporösen Verbindung (22),
• Glätten des thermischen Fettes (13) mittels eines Glätters, der auf den Rahmen (31) aus der mikroporösen Verbindung (22) aufgelegt wird, wodurch der Film aus thermischem Fett (13), umgeben von der mikroporösen Verbindung (22), hergestellt werden kann, und
• Aufbringen des zweiten Objekts (12) auf dem Film aus thermischem Fett (13), wodurch eine zweite Seite (32) der mikroporösen Verbindung (22) zumindest teilweise mit dem zweiten Objekt (12) in Kontakt gebracht wird.

12. Verfahren nach Anspruch 11, umfassend einen weiteren Schritt zur Montage von Befestigungsmitteln (24) zwischen dem ersten Objekt (11) und dem zweiten Objekt (12).

13. Verfahren nach einem der Ansprüche 11 bis 12, umfassend einen vorbereitenden Schritt, der darin besteht, eine Schutzfolie von der mikroporösen Verbindung (22) abzuziehen, sodass eine Seite (30) der mikroporösen Verbindung (22) sichtbar wird, die eine Klebefolie aufweist, wobei mit dem nächsten Schritt, d.h. dem Ausbringen der mikroporösen Verbindung (22), die Klebefolie mit dem ersten Objekt (11) in Kontakt gebracht wird.

14. Verfahren nach Anspruch 13, bei dem der Schritt des Abziehens der Schutzfolie und der Schritt des Aufbringens der mikroporösen Verbindung (22) auf dem ersten Objekt (11) mit Hilfe einer Abrollvorrichtung gleichzeitig durchgeführt werden.

15. Verfahren nach einem der Ansprüche 11 bis 14, das nach dem Schritt des Glättens des thermischen Fettes (13) einen Schritt des Abziehens eines Klebestreifens, der zuvor auf einer Seite (32) der mikroporösen Verbindung (22) angebracht wurde, umfasst.

## Claims

1. A thermal interface device, **characterised in that** it comprises a film of thermal grease (13) intended to be inserted between a first object (11) and a second object (12), and a microporous seal (22) encircling the periphery of the film of thermal grease (13).

2. The thermal interface device according to the preceding claim, wherein the microporous seal (22) is oleophobic and permeable to air.

3. The device according to any of the preceding claims, the microporous seal (22) of which comprises a microporous film of polytetrafluoroethylene (PTFE).

4. The device according to any of the preceding claims, of which the microporous seal (22) comprises an electrically conductive filler.

5. The device according to any of the preceding claims, wherein the thermal grease comprises a binder and a thermally conductive filler promoting heat transfer, the average diameter of the pores of the microporous seal being less than the average diameter of the filler so as to prevent the migration of the thermally conductive filler.

6. The device according to any of the preceding claims, of which the microporous seal (22) exhibits a friction coefficient greater than 0.25.

7. The device according to any of the preceding claims, of which the microporous seal (22) exhibits a thickness of between 150 and 180 µm.

8. A microporous seal (22) of a thermal interface device (20) according to any of Claims 1 to 7, **characterised in that** it comprises, on one face (30), an adhesive film and a mould-stripping film; the mould-stripping film being able to be removed to allow said face (30) of the microporous seal (22) to adhere to one of the two objects (11, 12) by means of the adhesive film.

9. The microporous seal (22) of a thermal interface device (20) according to any of Claims 1 to 7, **characterised in that** it comprises, on one face (32), an adhesive tape that can be removed so as to allow said face (32) of the microporous seal (22) to be placed in contact with one of the two objects (11, 12).

10. An item of equipment (23) comprising a first object (11) and a second object (12), **characterised in that** it comprises a thermal interface device (20) according to any of Claims 1 to 7 inserted between the first object (11) and the second object (12).

11. A method of manufacturing an item of equipment (23) according to Claim 10, **characterised in that** it comprises steps consisting of:
• depositing the microporous seal (22) on the first object (11), placing a first face (30) of the microporous seal (22) in contact with the first object (11), and in such a way as to form a closed frame (31) on the first object (11),
• depositing thermal grease (13) on the first object (11), inside the closed frame (31) of microporous seal (22),
• smoothing the thermal grease (13) by means of a smoothing tool bearing on the frame (31) of microporous seal (22), making it possible to form the film of thermal grease (13) encircled by the microporous seal (22), and
• depositing the second object (12) on the film of thermal grease (13), placing a second face (32) of the microporous seal (22) at least partially in contact with the second object (12).

12. The method according to Claim 11, comprising a subsequent step of mounting fixing means (24) between the first object (11) and the second object (12).

13. The method according to any of Claims 11 to 12, comprising a preliminary step consisting of removing a mould-stripping film from the microporous seal (22) so as to uncover a face (30) of the microporous seal (22) comprising an adhesive film, the next step of depositing the microporous seal (22) placing the adhesive film in contact with the first object (11).

14. The method according to Claim 13, of which the step of removing the mould-stripping film and the step of depositing the microporous seal (22) on the first object (11) are performed simultaneously by means of a roll dispenser.

15. The method according to any of Claims 11 to 14, comprising upon completion of the step of smoothing the thermal grease (13), a step of removing an adhesive tape previously arranged on a face (32) of the microporous seal (22).w
